# EUROPÄISCHE PATENTSCHRIFT

(11) **EP 3 737 860 B1**
(45) Veröffentlichungstag und Bekanntmachung des Hinweises auf die Patenterteilung: **20.04.2022**
(21) Anmeldenummer: 19700216.5
(22) Anmeldetag: 08.01.2019
(51) Int. Cl.: F03D 80/30

(54) **WINDENERGIEANLAGEN-ROTORBLATT**
WIND TURBINE ROTOR BLADE
PALE D'ÉOLIENNE

(30) Priorität: 09.01.2018 DE 102018100302
(43) Veröffentlichungstag der Anmeldung: 18.11.2020
(73) Patentinhaber: Wobben Properties GmbH, 26607 Aurich (DE)
(72) Erfinder: VINKE, Daniel, 26607 Aurich (DE); ENGELHARDT, Sebastian, 26605 Aurich (DE)
(74) Vertreter: Eisenführ Speiser
(86) Internationale Anmeldenummer: PCT/EP2019/050276
(87) Internationale Veröffentlichungsnummer: WO 2019/137881

(56) Entgegenhaltungen:
- EP-A1- 3 255 274
- GB-A- 2 503 260
- US-A1- 2007 183 888
- US-A1- 2011 223 031
- US-A1- 2013 280 087

## Beschreibung

Insbesondere bei Windenergieanlagen, welche in der Nähe von Flugplätzen aufgestellt werden, kann es aufgrund der sich bewegenden Rotorblätter zu Radarreflektionen kommen, welche nicht konstant sind. Diese nicht konstanten Radarreflektionen können die Radarsysteme der Flughäfen bzw. Flugplätze stören.

Daher müssen die durch eine Windenergieanlage erzeugte Radarreflektionen reduziert werden, um sicherstellen zu können, dass Windparks, bestehend aus einer Mehrzahl von Windenergieanlagen, in der Nähe von Flughäfen oder Flugplätzen bzw. Radarstationen genehmigt werden können.

In der prioritätsbegründenden deutschen Patentanmeldung hat das Deutsche Patent- und Markenamt die folgenden Dokumente recherchiert: EP 3 173 619 A1 und GB 2 488 561 A.

GB 2 503 260 A betrifft Verbundwerkstoffstrukturen, wie z. B. Windturbinenblätter, die radarabsorbierende Materialien (RAM) zur Verringerung des Radarquerschnitts (RCS) der Verbundwerkstoffstruktur enthalten.

Es ist daher eine Aufgabe der vorliegenden Erfindung, eine Windenergieanlage mit einer reduzierten Radarreflektion vorzusehen. Insbesondere ist es eine Aufgabe der vorliegenden Erfindung, Windenergieanlagen-Rotorblätter vorzusehen, welche eine Reduzierung der Radarreflektionen ermöglichen.

Diese Aufgabe wird durch ein Windenergieanlagen-Rotorblatt nach Anspruch 1 gelöst.

Somit weist ein Windenergieanlagen-Rotorblatt eine Rotorblatthülle und ein Blitzschutzsystem auf. Das Blitzschutzsystem weist wenigstens ein Blitzschutzkabel und einen Halter für das Blitzschutzkabel auf. Der Halter kann innen an der Rotorblatthülle befestigt werden. Insbesondere kann der Halter innen an der Rotorblatthülle verklebt werden. Der Halter weist einen ersten Abschnitt zur Befestigung an der Rotorblatthülle und zur Aufnahme des Blitzschutzkabels auf sowie einen zweiten Abschnitt, welcher auf dem Abschnitt befestigt wird, zur kompletten Umhüllung des ersten Abschnitts sowie des darin befindlichen Blitzschutzkabels. Der erste und/oder zweite Halterabschnitt weist einen radarabsorbierenden Abschnitt sowie ein elektrisch isolierendes Material auf.

Mit dem elektrisch isolierenden Material, welches sich insbesondere zwischen der Rotorblatthülle und dem Blitzschutzkabel befindet, kann sichergestellt werden, dass es bei einem Blitzschlag nicht zu Schäden an dem Material der Rotorblatthülle kommt. Durch das radarabsorbierende Material kann sichergestellt werden, dass die Radarreflektionen des Windenergieanlagen-Rotorblattes erheblich verringert werden.

Gemäß einem Aspekt der vorliegenden Erfindung ist der radarabsorbierende Abschnitt als Kern des ersten und/oder zweiten Abschnitts ausgebildet und aus einem radarabsorbierenden Material hergestellt. Das elektrisch isolierende Material umgibt dann den radarabsorbierenden Kern als Hülle.

Gemäß einem Aspekt der vorliegenden Erfindung weist der Halter ein erstes Teil auf, welches auf der Rotorblatthülle befestigt wird. Das erste Teil weist eine Ausnehmung zur Aufnahme des Blitzschutzkabels auf. Der Halter weist ein zweites Teil auf, welches als Deckel oder Abdeckung ausgestaltet ist und über bzw. auf dem ersten Teil befestigt wird. Gemäß einem weiteren Aspekt der vorliegenden Erfindung weist das erste Teil des Halters einen geraden Klebeabschnitt, insbesondere aus dem elektrisch isolierenden Material, auf. Das erste Teil des Halters weist ferner einen im Wesentlichen U-förmigen Halteabschnitt zur Aufnahme des Blitzschutzkabels auf. Ein Deckel (als zweites Teil) wird über das erste Teil platziert und überdeckt dann zusammen mit dem ersten Abschnitt komplett das Blitzschutzkabel. Das erste und zweite Teil besteht jeweils aus einem elektrisch isolierenden Material mit einem radarabsorbierenden Material als Kern bzw. als innere Schicht. Gemäß einem weiteren Aspekt der vorliegenden Erfindung ist das radarabsorbierende Material als ein Salisbury Screen oder ein Dallenbach Layer ausgestaltet.

Das elektrisch isolierende Material kann aus TPU hergestellt sein.

Ein geeignetes Verfahren zum Herstellen eines Windenergieanlagen-Rotorblattes kann vorgesehen werden.

Dazu wird eine Rotorblatthülle vorgesehen. Anschließend wird ein Halter für ein Blitzschutzkabel auf der Innenseite der Rotorblatthülle befestigt, insbesondere verklebt.

Hierbei wird insbesondere ein erstes Teil des Halters bestehend aus einem elektrisch isolierenden Material an der Innenseite der Rotorblatthülle befestigt. In dem ersten Teil ist ferner ein radarabsorbierendes Material vorgesehen. Anschließend wird das Blitzschutzkabel in das erste Teil platziert und ein zweites Teil, beispielsweise in Form eines Deckels oder einer Abdeckung, wird über das erste Teil platziert, so dass das Blitzschutzkabel komplett von dem ersten und zweiten Teil umgeben ist. Das zweite Teil besteht ebenfalls aus einem elektrisch isolierenden Material mit einem radarabsorbierenden Material. Damit wird das Blitzschutzkabel komplett von einem elektrisch isolierenden Material sowie von einem radarabsorbierenden Material umgeben. Hierbei können sich das erste und zweite Teil überdecken, so dass sowohl das elektrisch isolierende Material als auch das radarabsorbierende Material des ersten und zweiten Teils sich überdecken.

Ein Blitzschutzkabelhalter für ein Windenergieanlagen-Rotorblatt, kann vorgesehen werden, mit einem ersten Teil, welches an einer Rotorblattinnenfläche mit seiner ersten Seite befestigbar ist und welches eine Ausnehmung zur Aufnahme eines Blitzschutzkabels aufweist, und einem Decke! oder einer Abdeckung, welche als zweites Teil auf dem ersten Teil platziert wird, so dass sich das erste und zweite Teil überdecken. Das erste und/oder zweite Teil weist jeweils ein elektrisch isolierendes Material sowie ein radarabsorbierendes Material auf.

Gemäß einem Aspekt der vorliegenden Erfindung wird ein Windenergieanlagen-Rotorblatt vorgesehen, welches eine Rotorblatthülle und ein Blitzschutzsystem mit mindestens einem Blitzschutzkabel aufweist. Das Blitzschutzkabel weist einen metallischen elektrischen Leiter, einen isolierenden Abschnitt sowie radarabsorbierendes Material auf. Der isolierende Abschnitt umgibt den metallischen Leiter. Das radarabsorbierende Material kann in Partikelform in dem isolierenden Material vorgesehen sein. Alternativ dazu kann das radarabsorbierende Material als Mantel um den elektrischen Leiter vorgesehen sein. Alternativ dazu kann das radarabsorbierende Material zwischen dem elektrischen Leiter und dem Isolationsabschnitt vorgesehen sein, Weitere Ausgestaltungen der Erfindung sind Gegenstand der Unteransprüche.

Ausführungsbeispiele und Vorteile der Erfindung werden nachstehend unter Bezugnahme auf die Zeichnung näher erläutert:
- Fig. 1: zeigt eine schematische Darstellung einer Windenergieanlage gemäß der Erfindung,
- Fig. 2: zeigt eine schematische Darstellung eines Windenergieanlagen-Rotorblattes,
- Fig. 3: zeigt eine schematische Schnittansicht eines Blitzschutzkabelhalters gemäß einem Aspekt der vorliegenden Erfindung, und
- Fig. 4A: zeigen jeweils einen schematischen Querschnitt eines Blitzschutz-
- bis Fig. 4F: kabels gemäß einem weiteren Aspekt der Erfindung.

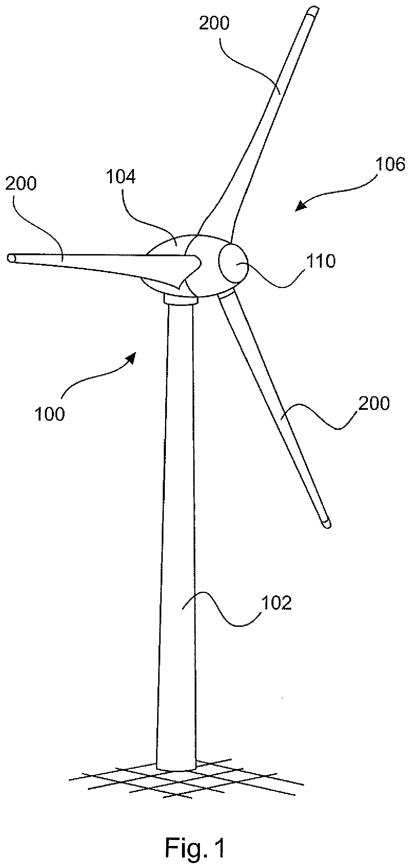

Fig. 1 zeigt eine Windenergieanlage 100 mit einem Turm 102 und einer Gondel 104. An der Gondel 104 ist ein Rotor 106 mit drei Rotorblättern 200 und einem Spinner 110 angeordnet. Der Rotor 106 wird im Betrieb durch den Wind in eine Drehbewegung versetzt und treibt dadurch einen Generator in der Gondel 104 an. Das Rotorblatt 200 gemäß der Erfindung wird typischerweise aus zwei Halbschalen 230 hergestellt, weiche dann aufeinander verklebt werden. Das Rotorblatt weist eine Rotorblattspitze 210 sowie eine Rotorblattwurzel 220 auf.

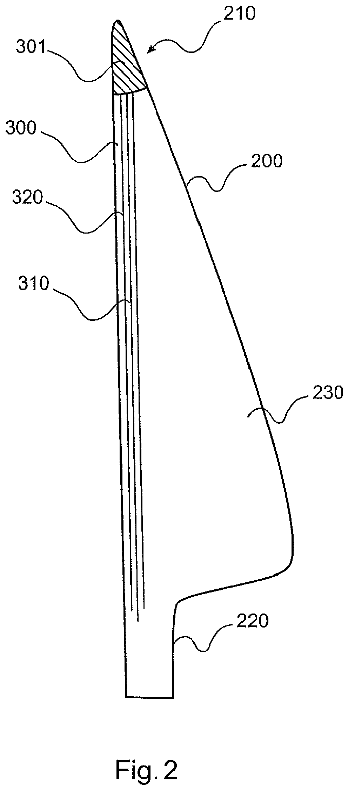

Fig. 2 zeigt eine schematische Darstellung eines Windenergieanlagen-Rotorblattes gemäß der Erfindung. Das Rotorblatt 200 weist eine Rotorblattspitze 210 sowie eine Rotorblattwurzel 220 auf. Das Rotorblatt weist ferner eine Rotorblatthülle 230 auf, welche beispielsweise aus zwei Halbschalen besteht, die aufeinander verklebt sind.

Ferner weist das Rotorblatt 200 ein Blitzschutzsystem 300 auf. Im Bereich der Rotorblattspitze 210 kann ein Blitzrezeptor 301 vorgesehen sein. Das Blitzschutzsystem 300 weist ferner ein Blitzschutzkabel 310 sowie einen Halter 320 für das Blitzschutzkabel 310 auf. Das Blitzschutzkabel 310 kann sich beispielsweise von dem Blitzrezeptor 301 bis in den Bereich der Rotorblattwurzel 220 erstrecken. Von dort aus kann das Blitzschutzkabel durch eine Nabe, die Gondel sowie dem Turm der Windenergieanlage nach unten geführt und mit Erde verbunden sein.

Der Blitzschutzkabelhalter 320 wird an der Rotorblatthülle 230 befestigt und das Blitzschutzkabel 320 wird in dem Halter 310 platziert.

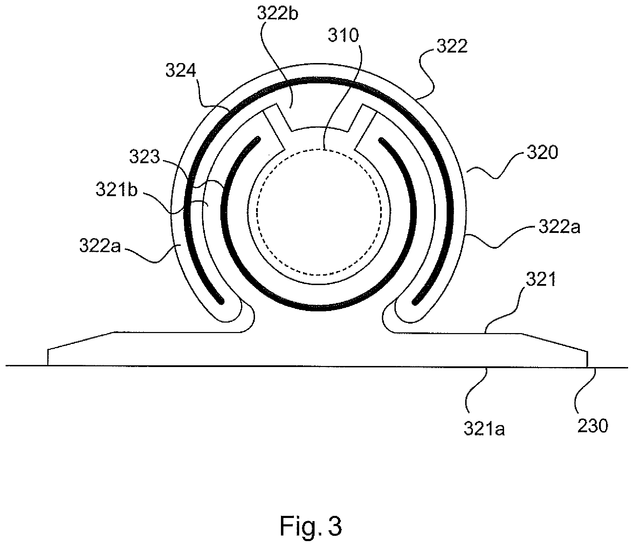

Fig. 3 zeigt einen schematischen Querschnitt des Blitzschutzkabelhalters 320 gemäß der Erfindung. Der Halter 320 weist ein erstes Teil 321 auf, welches an einer Rotorblatthülle 230 des Rotorblattes befestigt werden kann. Hierzu können insbesondere ein erstes gerades Ende 321a auf bzw. an dem Material der Rotorblatthülle 230 verklebt werden. Das erste Teil 321 weist ferner einen Aufnahmeabschnitt 321b auf, welcher beispielsweise im Wesentlichen U-förmig ausgestaltet ist und eine Öffnung aufweist, durch welche das Blitzschutzkabel 320 in dem ersten Teil 321 des Halters 320 platziert werden kann.

Der Halter 320 weist ferner eine Abdeckung oder einen Deckel 322 auf, welcher über dem Aufnahmeabschnitt 321b des ersten Teils platziert werden kann. Der Aufnahmeabschnitt 321b weist einen Kern oder eine Schicht aus radarabsorbierendem Material 323 sowie ein elektrisch absorbierendes Material 321b auf, welches das radarabsorbierende Material 323 umgibt.

Das zweite Teil 322 des Halters kann im Wesentlichen U-förmig oder C-förmig ausgestaltet sein und kann über dem ersten Teil 321 des Halters 320 platziert werden, um eine Öffnung in dem ersten Teil 321 zu verschließen. Das zweite Teil 322 des Halters 320 weist einen radarabsorbierenden Kern 323 oder eine radarabsorbierende Schicht 324 sowie eine die Schicht umgebendes elektrisch isolierendes Material auf.

Wenn das Blitzschutzkabel 310 in dem Aufnahmeabschnitt 321b platziert ist und die Abdeckung 322 auf dem Aufnahmeabschnitt 321b platziert ist, dann ist das Blitzschutzkabel 310 komplett von einem elektrisch isolierenden Material sowie von einem radarabsorbierenden Material umgeben. Hierbei können sich der Aufnahmeabschnitt 321b und das zweite Teil 322 überlappen.

Der Aufnahmeabschnitt 321b kann insbesondere zwei Arme aufweisen, welche jeweils ein radarabsorbierendes Material und ein dies umgebendes elektrisch isolierendes Material aufweisen. Das zweite Teil 322 kann ebenfalls zwei Arme aufweisen, welche die Arme des ersten Teils umgeben können, um damit das Blitzschutzkabel komplett zu umgeben und damit eine optimale Radarabsorption zu ermöglichen.

Dadurch, dass erfindungsgemäß der radarabsorbierende Kern bzw. die radarabsorbierende Schicht komplett von einem elektrisch isolierenden Material umgeben ist, ist zum einen ein effektiver Blitzschutz gewährleistet, und zum anderen können die Radarabsorptionen effektiv verringert werden. Damit wird eine effektive Möglichkeit geschaffen, den Einbauaufwand eines Blitzschutzsystems mit radarabsorbierenden Eigenschaften bei der Rotorblattfertigung zu reduzieren.

Das elektrisch isolierende Material kann aus einem thermoplastischen Polyurethan TPU hergestellt sein.

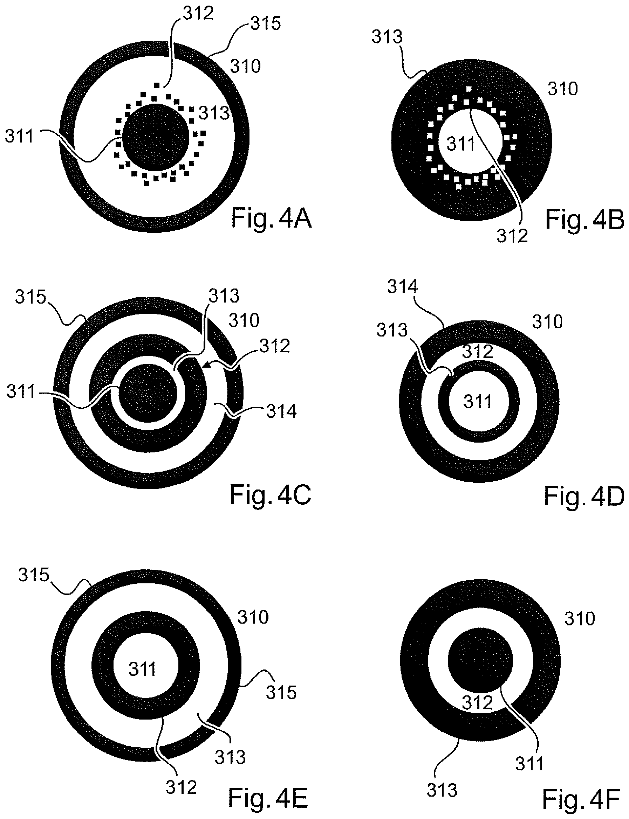

Fig, 4A bis 4F zeigen jeweils einen schematischen Querschnitt eines Blitzschutzkabels gemäß einem weiteren Aspekt der Erfindung. Das Blitzschutzkabel gemäß dem weiteren Aspekt der vorliegenden Erfindung kann in der Windenergieanlage gemäß Fig. 1 sowie in dem Rotorblatt gemäß Fig. 2 verwendet werden. In den Fig. 4A und 4B ist jeweils ein Blitzschutzkabel mit einem metallischen Leiter 311, einem Isolator 313 sowie radarabsorbierendes Material 312 beispielsweise in Form von Partikeln vorgesehen, welche innerhalb der elektrischen Isolierung 313 verteilt sind. Während in dem Kabel von Fig. 4A ein äußerer Mantel 315 vorgesehen ist, fehlt dieser Mantel bei dem Blitzschutzkabel von Fig. 4B.

In den Fig. 4C und 4D ist ein weiteres Blitzschutzkabel vorgesehen, welches einen elektrischen Leiter 311, ein den Leiter umgebenden isolierenden Abschnitt 313, ein radarabsorbierendes Material 312, einen weiteren isolierenden Abschnitt 314 sowie in Fig. 4C einen äußeren Mantel 315 aufweist. Der Mantel 315 fehlt in dem Blitzschutzkabel von Fig. 4D.

Damit ist in den Blitzschutzkabeln gemäß Fig. 4C und Fig. 4D das radarabsorbierende Material 312 als Vollmaterial dargestellt, welches den isolierenden Abschnitt 313 umgibt.

In den Fig. 4E und 4F ist ebenfalls ein Querschnitt eines Blitzschutzkabels dargestellt. Das Blitzschutzkabel weist einen metallischen Leiter 311 als Kern, ein radarabsorbierendes Vollmaterial 312 auf, welches den Kern umgibt, sowie einen isolierenden Abschnitt 313, weicher das radarabsorbierende Material 312 umgibt. Optional kann - wie in Fig. 4E gezeigt - ein äußerer Mantel 315 vorgesehen sein. Dieser Mantel 315 fehlt in dem Blitzschutzkabel gemäß Fig. 4F.

Gemäß dem weiteren Ausführungsbeispiel der Erfindung wird somit ein vollisoliertes Blitzschutzsystem mit einem Blitzschutzleiter bzw. Blitzschutzkabel vorgesehen, welches eine niedrige Radarreflektion ermöglicht.

Gemäß dem weiteren Aspekt der vorliegenden Erfindung ist ein Blitzschutzkabel bzw. ein Blitzschutzkabelbaum vorgesehen, welches im Inneren einen metallischen Leiter und eine elektrische Isolierung um den Leiter aufweist. Das radarabsorbierende Material dient zur Reduktion der Radarreflektion. Das radarabsorbierende Material 312 kann zwischen dem elektrischen Leiter und der elektrischen Isolierung vorgesehen sein. Alternativ dazu kann das radarabsorbierende Material auch um die elektrische Isolierung herum vorgesehen sein.

Das radarabsorbierende Material kann ein Salisbury Screen, einen magnetischen Absorber oder ein Dallenbach Layer darstellen. Gemäß der Erfindung wird eine ausreichende elektrische Isolierung zwischen dem radarabsorbierenden Absorber sowie der Umgebung vorgesehen. Dies wird durch die elektrische Isolierung des elektrischen Leiters erreicht.

Die Blitzschutzkabel gemäß den Fig. 4A bis 4F können in einem Blitzschutzleiterhalter 320 gemäß Fig. 3 vorgesehen werden, wobei in diesem Fall auf die radarabsorbierende Schicht 323 verzichtet werden kann.

## Patentansprüche

1. Windenergieanlagen-Rotorblatt (200), mit
einer Rotorblatthülle (230), und
einem Blitzschutzsystem (300), welches mindestens ein Blitzschutzkabel (310) und einen Blitzschutzkabelhalter (320) aufweist,
wobei der Blitzschutzkabelhalter (320) in bzw. an der Innenseite der Rotorblatthülle (230) befestigt ist,
**dadurch gekennzeichnet, dass**
der Blitzschutzkabelhalter (320) ein erstes Teil (321) und ein zweites Teil (322) aufweist, wobei das erste Teil (321) an einer Innenseite der Rotorblatthülle (230) befestigt ist und einen Aufnahmeabschnitt (321b) zur Aufnahme des Blitzschutzkabels (310) aufweist,
wobei das zweite Teil (322) als Deckel oder Abdeckung ausgestaltet ist und über dem Aufnahmeabschnitt (321b) platziert wird,
wobei das erste und zweite Teil (321, 322) jeweils einen radarabsorbierenden Kern oder eine radarabsorbierende Schicht (323) sowie ein elektrisch isolierendes Material aufweist, welches den radarabsorbierenden Kern bzw. die radarabsorbierende Schicht (323) umgibt.

2. Windenergieanlagen-Rotorblatt nach Anspruch 1, wobei
das erste Teil (321) des Halters (320) einen geraden Klebeabschnitt (321a), insbesondere aus einem elektrisch isolierenden Material, sowie einen Aufnahmeabschnitt (321b) aufweist, welcher radarabsorbierendes Material (323) sowie dieses umgebende elektrisch isolierende Material aufweist,
wobei der Aufnahmeabschnitt U-förmig oder C-förmig ausgestaltet ist und zur Aufnahme des Blitzschutzkabels (310) dient,
wobei das zweite Teil (322) C-förmig oder U-förmig ausgestaltet ist und über dem Aufnahmeabschnitt (321b) platziert ist.

3. Windenergieanlagen-Rotorblatt nach einem der Ansprüche 1 oder 2,
wobei das radarabsorbierende Material ein Salisbury Screen oder ein Dallenbach Layer darstellt.

4. Windenergieanlagen-Rotorblatt nach einem der Ansprüche 1 bis 3,
wobei das elektrisch isolierende Material TPU darstellt.

5. Windenergieanlage, mit einem Windenergieanlagen-Rotorblatt (200) nach einem der Ansprüche 1 bis 4.

## Claims

1. A wind turbine rotor blade (200) comprising
a rotor blade casing (230), and
a lightning protection system (300) having at least one lightning protection cable (310) and a lighting protection cable holder (320),
wherein the lighting protection cable holder (320) is fixed in or to the inside of the rotor blade casing (230),
wherein the lighting protection cable holder (320) has a first part (321) and a second part (322), wherein the first part (321) is fixed to an inside of the rotor blade casing (230) and has a receiving portion (321b) for receiving the lighting protection cable (310),
wherein the second part (322) is in the form of a cover or covering means and is placed over the receiving portion (321b), and
wherein the first and second parts (321, 322) each have a radar-absorbing core or a radar-absorbing layer (323) and an electrically insulating material which surrounds the radar-absorbing core or the radar-absorbing layer (323).

2. A wind turbine rotor blade according to claim 1 wherein
the first part (321) of the holder (320) has a straight adhesive portion (321a), in particular of an electrically insulating material, and a receiving portion (321b) which has radar-absorbing material (323) and electrically insulating material surrounding same,
wherein the receiving portion is of a U-shaped or C-shaped configuration and serves to receive the lighting protection cable (310),
wherein the second part (322) is of a C-shaped or U-shaped configuration and is placed over the receiving portion (321b).

3. A wind turbine rotor blade according to one of claims 1 and 2
wherein the radar-absorbing material represents a Salisbury screen or a Dallenbach layer.

4. A wind turbine rotor blade according to one of claims 1 to 3
wherein the electrically insulating material represents TPU.

5. A wind turbine comprising
a wind turbine rotor blade (200) according to one of claims 1 to 4.

## Revendications

1. Pale de rotor d'éolienne (200) avec
une enveloppe de pale de rotor (230), et
un système de protection contre la foudre (300) qui présente au moins un câble de protection contre la foudre (310) et un support de câble de protection contre la foudre (320),
dans laquelle le support de câble de protection contre la foudre (320) est fixé dans ou au côté intérieur de l'enveloppe de pale de rotor (230),
**caractérisée en ce que**
le support de câble de protection contre la foudre (320) présente une première partie (321) et une seconde partie (322), dans laquelle la première partie (321) est fixée à un côté intérieur de l'enveloppe de pale de rotor (230) et présente une section de réception (321b) pour la réception du câble de protection contre la foudre (310),
dans laquelle la seconde partie (322) est configurée comme couvercle ou recouvrement et est placée au-dessus de la section de réception (321b),
dans laquelle les première et seconde parties (321, 322) présentent respectivement une âme absorbant le radar ou une couche (323) absorbant le radar ainsi qu'un matériau électriquement isolant qui entoure l'âme absorbant le radar ou la couche absorbant le radar (323).

2. Pale de rotor d'éolienne selon la revendication 1, dans laquelle
la première partie (321) du support (320) présente une section de collage (321a) droite, en particulier en un matériau électriquement isolant, ainsi qu'une section de réception (321b) qui présente du matériau absorbant le radar (323) ainsi que du matériau électriquement isolant l'entourant,
dans laquelle la section de réception est configurée en forme de U ou de C et sert à la réception du câble de protection contre la foudre (310),
dans laquelle la seconde partie (322) est configurée en forme de C ou de U et est placée au-dessus de la section de réception (321b).

3. Pale de rotor d'éolienne selon l'une quelconque des revendications 1 ou 2,
dans laquelle le matériau absorbant le radar représente un écran Salisbury ou une couche Dallenbach.

4. Pale de rotor d'éolienne selon l'une quelconque des revendications 1 à 3,
dans laquelle le matériau électriquement isolant représente du TPU.

5. Eolienne avec une pale de rotor d'éolienne (200) selon l'une quelconque des revendications 1 à 4.
